Europäisches Patentamt

European Patent Office

Office européen des brevets

(19)

(11) Publication number: 0 363 069
A2

## (12) EUROPEAN PATENT APPLICATION

(21) Application number: 89309823.6

(22) Date of filing: 27.09.89

(51) Int. Cl.5: **H01L 31/103 , H01L 31/118 , H01L 31/18**

(30) Priority: 04.10.88 GB 8823246

(43) Date of publication of application:
**11.04.90 Bulletin 90/15**

(84) Designated Contracting States:
**DE FR IT NL**

(71) Applicant: **UNITED KINGDOM ATOMIC
ENERGY AUTHORITY**
**11 Charles II Street**
**London SW1Y 4QP(GB)**

(72) Inventor: **Harper, Ruth Elizabeth**
**Gage Cottage Rowstock**
**Didcot Oxfordshire(GB)**
Inventor: **Rawlings, Kenneth John**
**108 Stockham Park Wantage**
**Oxfordshire OX12 9HH(GB)**
Inventor: **Totterdell, David Harold John**
**Meadows Edge York Road**
**West Hagbourne Didcot Oxfordshire(GB)**

(74) Representative: **Wood, Paul Austin et al**
**United Kingdom Atomic Energy Authority**
**Patents Branch B329 Harwell Laboratory**
**Oxfordshire OX11 0RA(GB)**

(54) **Radiation detector.**

(57) A radiation detector comprising, a wafer of semiconductor material having a high-low junction formed on one planar surface, the high-low junction also continuing around the edge of the wafer and an annular region at the periphery of the reverse planar surface of the wafer, an electrically isolating region formed around the inner edge of the annular region of the reverse planar surface of the wafer, a rectifying junction formed over the remainder of the reverse surface of the wafer and means for making electrical contact to the high-low and rectifying junctions.

EP 0 363 069 A2

# RADIATION DETECTOR

The present invention relates to radiation detectors comprising a wafer of semiconductor material having at least one rectifying junction formed therein and contacts established thereto so that electrical signals can be generated and detected in response to the incidence of ionising radiation upon the detector.

A known radiation detector of the above type comprises a circular wafer of silicon which has a $n^+p$ junction formed over one plane surface. The $n^+p$ junction also extends around the edge of the wafer and an annular region of the other plane surface of the wafer. Electrical contacts are made to the $n^+p$ annular region and the main body of the silicon wafer. Thus both contacts are made on one side of the wafer, leaving the other surface contact-free so maximising the radiation-sensitive area of the device as well as providing a surface which easily can be kept clean. However, this configuration does have some undesirable aspects; the equivalent circuit is poor and the wrap-round junction structure leads to a high junction capacitance together with a high series resistance. This degrades the energy resolution through the increased loading at the input to an associated pre-amplifier, which increases the amplifier noise. Also, these existing devices are vulnerable to wafer edge damage.

The present invention provides a radiation detector which has the same configuration as the above described device but avoids its shortcomings.

According to the present invention, there is provided a radiation detector comprising, a wafer of semiconductor material having a high-low junction formed on one planar surface, the high-low junction also continuing around the edge of the wafer and an annular region at the periphery of the reverse planar surface of the wafer, an electrically isolating region formed around the inner edge of the annular region of the reverse planar surface of the wafer, a rectifying junction formed over the remainder of the reverse surface of the wafer and means for making electrical contact to the high-low and rectifying junctions.

The planar configuration of the rectifying junction eliminates the high junction capacitance and series resistance of the existing design of radiation detector so improving the energy resolution of the device. Also, the dark current will be small due to the high-low junction and the electrically isolating region between it and the edge of the rectifying junction. Furthermore, wafer handling in production and use is less critical because damage to the edge of the wafer will not greatly affect the performance of the device. This is because, in use, the edge of the wafer will not be depleted so that even in the event of a chipped area occurring at the edge of the wafer and having a large carrier generation rate, the injected diffusion current will still be small compared with the total dark current.

Preferably, the wafer is made of n-type silicon, the high-low junction is an $n^+n$ junction, the rectifying junction is a $p^+n$ junction and the electrical isolation between the $p^+n$ and $n^+n$ junctions is formed by oxide passivation of the silicon.

The invention will now be described, by way of example, with reference to the accompanying drawings, in which,

Figure 1 is a schematic cross-section of a radiation detector embodying the invention;

Figure 2 is a schematic cross-section of the edge region of the embodiment of Figure 1 showing the nature of this region in use;

Figure 3 illustrates one fabrication sequence for the manufacture of a radiation detector embodying the invention and

Figure 4 illustrates another fabrication sequence for the manufacture of a radiation detector embodying the invention.

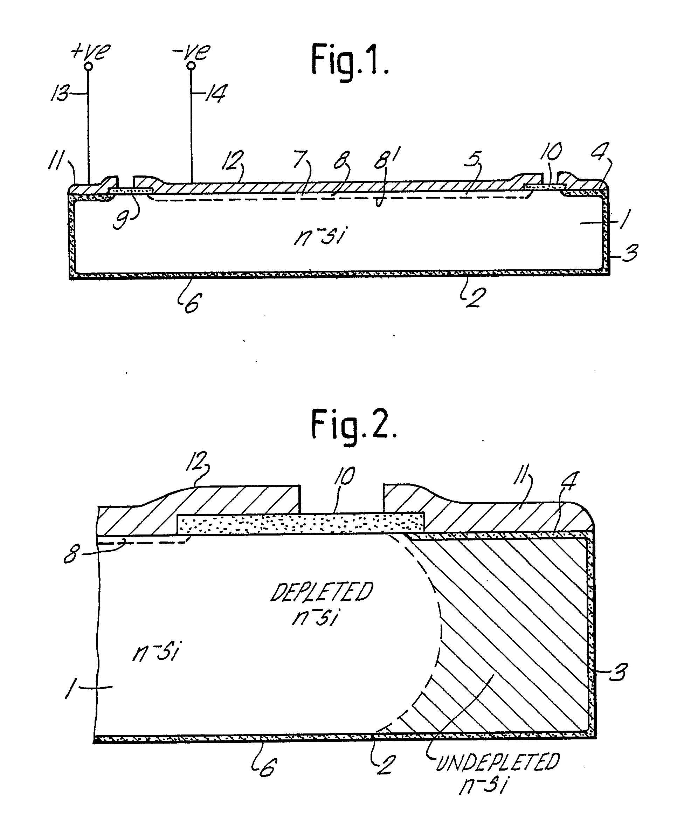

Referring to figure 1, a radiation detector embodying the invention consists of a circular wafer 1 of n-type silicon. One planar surface 2, the edge 3 and a peripheral annular region 4 of the other planar surface 5 are doped with phosphorus to produce a surface region 6 of $n^+$ silicon and provide an $n^+n$ junction 6. The central region 7 of the surface 5 is doped with boron to produce a surface region 8 of $p^+$ silicon and hence a $p^+n$ junction 8'. The annular region 9 between the peripheries of the $n^+n$ and $p^+n$ junctions is covered with an isolating annulus 10 of silicon dioxide. An annulus 11 and layer 12 of aluminium are deposited as shown to provide positive and negative contacts 13 and 14, respectively. When the device is operated under conditions of reverse bias, the wafer 1 depletes from the surface 5 towards the surface 2, but as shown in figure 2, even when the main part of the wafer 1 is fully depleted, the region under the annular $n^+n$ region 4 does not deplete. As described previously, this renders the performance of the device insensitive to damage to the edge of the wafer 1.

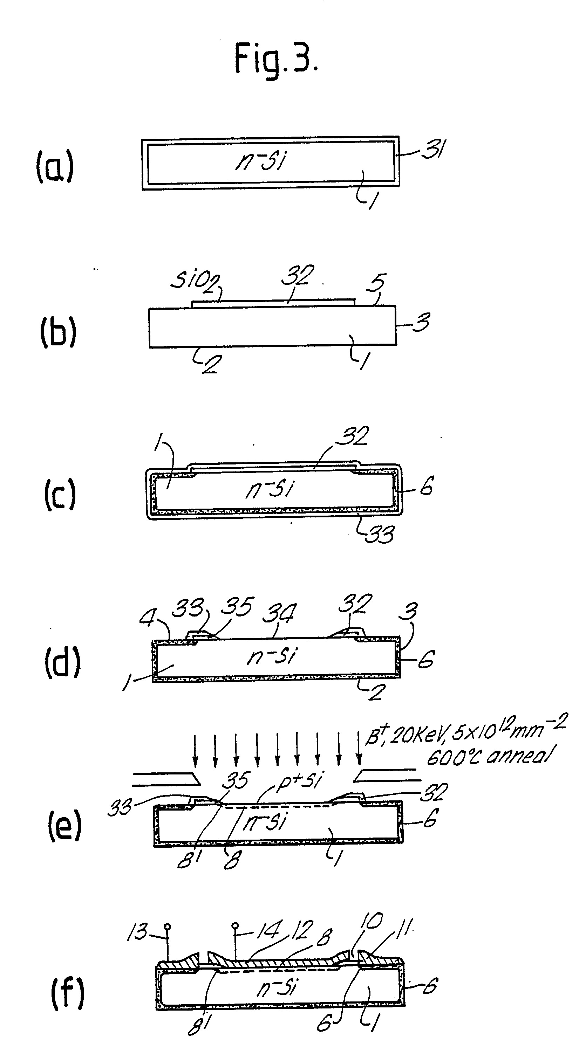

Referring to figure 3 which illustrates a process for producing a radiation detector embodying the invention, a wafer 1 of silicon is cleaned by any convenient process, such as are well known in the semiconductor art and therefore will not be described further, and is then oxidised in a dry/wet/dry oxidising process to produce an overall layer of silicon dioxide 31, as shown in figure 3(a). Again, such a process is well known in the semiconductor art. The layer 31 of silicon dioxide is then patterned by means of photolithography and wet chemical etching to leave a disk 32 of silicon dioxide, (as shown in figure 3b), on one face of the wafer 1 to act as a mask against phosphorus diffusion to create the low impedance wrap round $n^+n$ junction, which forms the next stage in the process. The phosphorus diffusion takes place from a layer of phosphosilicate glass 33 which is formed in situ by heating the wafer 1 to a temperature of $900\,^{\circ}$C in an atmosphere of phosphorus oxychloride ($POCl_3$). This stage is illustrated in figure 3(c). The $n^+$ layer 6 so formed will have a thickness of about 0.5 um and a sheet resistance of about 10 /square.

A window 34 is then opened in the silicon dioxide mask 32 and the layer 33 of phosphosilicate glass 33 covering the surface 2, edge 3 and region 4 of the wafer 1 are removed in one wet chemical etching step, as shown in figure 3(d), after the annulus of silicon dioxide 32 which is to remain has been protected with photo-resist. The window 34 will have a bevelled edge 35 because the phosphosilicate glass 4 etches faster than silicon dioxide. The next step is to implant boron into the window region 34 defined by the annulus of silicon dioxide 32, as shown in figure 3-(e). The bevelled edge 35 of the mask 32 has the beneficial effect of tapering the edge of the $p^+n$ junction $8'$ which increases the junction breakdown voltage by reducing the electric field in the vicinity of the edge of the junction $8'$ when the device is in use. The device is then annealed in dry nitrogen at $600\,^{\circ}$C for 30 minutes before a layer of aluminium is deposited on the whole of the back of the wafer 1. This layer of aluminium is then patterned by standard photolithographic techniques to leave an annulus 11 and a central disk 12 for the $n^+$ silicon contact and the $p^+$ silicon contact, respectively, as shown in figure 3(f).

The device is then subjected to a final annealing stage in a mixture of nitrogen and hydrogen at $400\,^{\circ}$C.

It should be noted that the central aluminium disk 12 extends onto the silicon dioxide annulus 10 beyond the edge of the $p^+n$ junction $8'$. This feature is an important factor in obtaining a high reverse breakdown voltage.

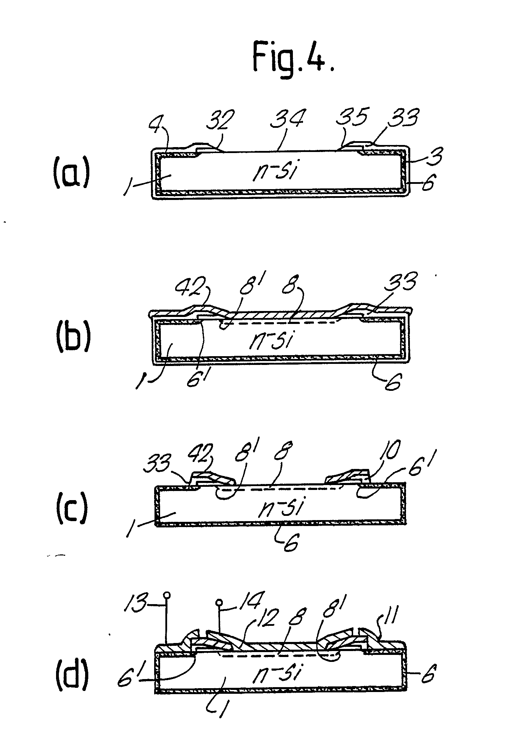

A second process for the manufacture of a radiation detector embodying the invention is illustrated in figure 4. The first three stages in the process are as previously described and so will not be repeated. Instead of implanting boron to produce the rectifying junction, however, a spin-on dopant is used. First a window 41 is etched in the over-all layer of phosphosilicate glass 33 and the silicon dioxide mask 32 together, as shown in figure 4(a). The phosphosilicate glass layer 33 is left in place on the remainder of the wafer 1 to prevent counter doping of the edge 3 and annular region 4 of the wafer 1 with boron. A uniform layer of boric oxide is then deposited on the surface 5 of the wafer 1 by a spinning technique, again well-known in the semiconductor art, and fired to produce a layer 42 of borosilicate glass (figure 4(b). The layer 42 of borosilicate glass then acts as a source of boron to produce by diffusion of boron the heavily doped $p^+$ surface region 8 and $p^+n$ junction $8'$ in a manner analogous to that in which the $n^+$ surface region 6 and $n^+n$ junction $6'$ were produced. The wafer 1 is then heated to a temperature of $900\,^{\circ}$C for 60 minutes to produce a $p^+n$ junction depth of a few tenths of a micron and a $p^+$ sheet resistance of about 100 /square. The boron drive-in stage above will also increase the depth of the high-low ($n^+n$) junction $6'$ under the layer of phosphosilicate glass 33 by a factor of 2.

The majority of the layer of borosilicate glass 42 and the remainder of the layer of phosphosilicate glass 33 are then removed in a single wet etching step to leave the annulus of silicon dioxide 10 covered in both phosphosilicate and borosilicate glass, as shown in figure 4(c). To complete the device the aluminium is deposited and patterned as before and the device annealed, also as before.

Although the final devices have similar structures, those produced by the all-diffusion process are expected to have higher reverse bias breakdown voltages. This is due to the anticipated presence of residual damage in the silicon wafer 1 and the edge of silicon dioxide mask 10 arising from the ion implantation of the boron in the fifth stage (figure 4c) of the first process for the production of radiation detectors embodying the invention.

Detectors made according to either of the above processes can be modified to make good alpha particle spectrometers. All that is required is to etch a window in the $n^+$ layer of the surface 2 so as to remove this layer and then to implant arsenic to a dose of about $10^{13}$ ions per square millimetre at an energy of 30 keV. The device is then annealed to activate the implanted arsenic. This produces a shallow $n^+$ layer which should represent a dead layer of about 50 nm only. Straggle of alpha particles through such a layer should produce an energy broadening of 4.5 keV fwhm.

Detectors made by the second process which can withstand reverse bias voltages sufficient to produce an electric field strength of more than $10^3$V mm$^{-1}$ throughout the depleted volume have potential for use as heavy ion detectors. The high value of electric field within the depleted volume of the wafer 1 is required to strip the dense electron-hole plasma created by highly ionising heavy ions before significant recombination of the electric charges so generated occurs.

## Claims

1 A radiation detector wherein there is provided, a wafer (1) of semiconductor material having a high-low junction (6) formed on one planar surface (2), the high-low junction (6) also continuing around the edge (3) of the wafer (1) and an annular region (4) at the periphery of the reverse planar surface (5) of the wafer (1), an electrically isolating region (9) formed around the inner edge of the annular region (4) of the reverse planar surface (5) of the wafer (1), a rectifying junction (8') formed over the remainder of the reverse surface (5) of the wafer (1) and means (11, 12) for making electrical contact to the high-low and rectifying junctions (6, 8').

2 A radiation detector according to claim 1 wherein the wafer (1) is made of an n-type semiconductor material the high-low junction (6) is an $n^+n$ junction and the rectifying junction (8') is a $p^+n$ junction.

3 A radiation detector according to claim 1 or claim 2 wherein the rectifying junction (8') is produced by an ion implantation process.

4 A radiation detector according to claim 1 or claim 2 wherein the rectifying junction (8') is produced by a diffusion process.

5 A radiation detector according to claim 3 or claim 4 wherein the high-low junction (6) is produced by a diffusion process.

6 A radiation detector according to any preceding claim wherein the semiconductor material is silicon.

7 A radiation detector according to claim 6 wherein the electrically isolating region (9) is formed by oxide passivation of the silicon.

8 A radiation detector according to claim 6 or claim 7 wherein the high-low junction (6) is formed by heating the wafer (1) in an atmosphere of phosphorus oxychloride to form a layer of phosphosilicate glass (33) and maintaining the wafer at a temperature sufficient to cause phosphorus to diffuse from the phosphosilicate glass (33) into the wafer (1) where it is desired to form the high-low junction (6) and subsequently removing the layer of phosphosilicate glass (33).

9 A radiation detector according to claim 8 wherein the rectifying junction (8') is formed by the implantation of ions of boron subsequent to the removal of the layer of phosphosilicate glass (33).

10 A radiation detector according to claim 8 wherein the rectifying junction (8') is formed by initially removing the layer of phosphosilicate glass (33) only in the region where it is desired to form the rectifying junction (8'), covering that region with a uniform layer of boric oxide, heating the wafer (1) to a temperature sufficient to produce a layer of borosilicate glass (42) maintaining the wafer (1) at a temperature sufficient to cause diffusion of boron from the layer of borosilicate glass (42) into the wafer (1) so as to form the rectifying junction (8') and subsequently removing the borosilicate and phosphosilicate glasses (42, 33) from those regions of the wafer (1) where their presence is not required.

11 A radiation detector according to claim 2 adapted to act as a detector for alpha particles wherein the $n^+$ layer of the $n^+n$ junction (6) has a thickness in the region of 50 nm.

12 A radiation detector substantially as hereinbefore described and with reference to the accompanying drawings.

13 A method of producing a radiation detector substantially as hereinbefore described and with reference to figure 3 and 4 of the accompanying drawings.

# Fig.1.

# Fig.2.

# Fig.3.

# Fig.4.

(a)

(b)

(c)

(d)